# DEMANDE DE BREVET EUROPEEN

(11) **EP 4 633 042 A1**
(43) Date de publication de la demande: **15.10.2025**
(21) Numéro de dépôt: 25168976.6
(22) Date de dépôt: 07.04.2025
(51) Int. Cl.: H03M 1/18, H03M 3/00

(54) **DISPOSITIF ET PROCEDE DE CONVERSION ANALOGIQUE NUMERIQUE**

(30) Priorité: 10.04.2024 FR 2403712
(71) Demandeur: Dolphin Semiconductor, 38240 Meylan (FR)
(72) Inventeur: SAADE, Toni, 38240 MEYLAN (FR); D'ESPERONNAT, Damien, 38240 MEYLAN (FR); GILETTI, Paul, 38240 MEYLAN (FR)
(74) Mandataire: Cabinet Beaumont

(57) **Abrégé**

La présente description concerne un convertisseur analogique numérique (300), comprenant :
- un ou plusieurs comparateurs (304), chacun configuré pour comparer un signal analogique (VIN) avec un niveau de référence (REF) variable propre au comparateur ;
- un contrôleur (306) relié à une sortie de l'un ou plusieurs comparateurs (304) et configuré pour générer un signal de commande (CTRL) indiquant le niveau de référence (REF) de chaque comparateur (304) en fonction d'un signal de sortie de chacun de l'un ou plusieurs comparateurs et configuré pour générer un signal numérique (NUM) de sortie sur la base du signal de sortie de chacun de l'un ou plusieurs comparateurs.

## Description

### Domaine technique

La présente description concerne de façon générale les dispositifs et procédés de conversion analogique numérique.

### Technique antérieure

Un signal analogique peut être converti en un signal numérique par des convertisseurs analogique numérique comprenant par exemple un ensemble de comparateurs. Chaque comparateur compare alors le signal analogique à un niveau de référence fixe propre à chaque comparateur et le niveau du signal analogique est estimé à partir de l'ensemble des signaux de sortie des comparateurs. Le nombre de comparateurs d'un tel convertisseur augmente linéairement avec le nombre de niveaux de référence.

Plus le nombre de comparateurs compris dans le convertisseur est important, plus sa consommation en énergie et son encombrement sont élevés. Il existe donc un besoin pour un convertisseur analogique numérique ayant un niveau de consommation et/ou un encombrement relativement faible.

### Résumé de l'invention

Un mode de réalisation prévoit un convertisseur analogique numérique, comprenant :
- un ou plusieurs comparateurs, chacun configuré pour comparer un signal analogique avec un niveau de référence variable propre au comparateur ; et
- un contrôleur relié à une sortie de l'un ou plusieurs comparateurs et configuré pour générer un signal de commande indiquant le niveau de référence de chaque comparateur en fonction d'un signal de sortie de chacun de l'un ou plusieurs comparateurs et configuré pour générer un signal numérique de sortie sur la base du signal de sortie de chacun de l'un ou plusieurs comparateurs.

Selon un mode de réalisation, le signal analogique est suréchantillonné.

Selon un mode de réalisation, le niveau de référence de chaque comparateur est sélectionné parmi une pluralité de niveaux de tension discrète.

Selon un mode de réalisation, le nombre de comparateurs est supérieur ou égal à deux, et les niveaux de référence des comparateurs sont sélectionnés de sorte d'être des niveaux successifs parmi la pluralité de niveaux de tension discrète.

Selon un mode de réalisation, le convertisseur analogique numérique comprend en outre un générateur de niveaux de référence des comparateurs, comprenant un diviseur de tension formé d'une pluralité de résistances ou de diodes connectées en série.

Selon un mode de réalisation, le générateur de niveaux de référence comprend un multiplexeur configuré pour sélectionner les niveaux de référence sur la base du signal de commande.

Selon un mode de réalisation, le convertisseur analogique numérique comprend en outre au moins un convertisseur numérique analogique relié à une sortie du contrôleur et configuré pour convertir le signal de commande en un ou plusieurs niveaux de tension de référence fournis à l'un ou plusieurs comparateurs ou fournis à une ou plusieurs bornes d'alimentation en tension du générateur de niveaux de référence.

Selon un mode de réalisation, l'écart entre deux niveaux de référence successifs et la fréquence d'échantillonnage sont choisis de sorte que la variation d'amplitude du signal analogique entre deux échantillons successifs ne dépasse pas deux fois ledit écart.

Un autre mode de réalisation prévoit un convertisseur analogique numérique Delta-Sigma, comprenant le convertisseur analogique numérique décrit ci-dessus.

Un autre mode de réalisation prévoit un procédé de conversion analogique numérique, comprenant :
- la comparaison, par un ou plusieurs comparateurs d'un convertisseur analogique numérique, d'un signal analogique avec un niveau de référence variable propre au comparateur ;
- la génération d'un signal de commande, par un contrôleur relié à une sortie de l'un ou plusieurs comparateurs, indiquant le niveau de référence de chaque comparateur en fonction d'un signal de sortie de chacun de l'un ou plusieurs comparateurs ; et
- la génération d'un signal numérique de sortie, par le contrôleur, sur la base du signal de sortie de chacun de l'un ou plusieurs comparateurs.

Selon un mode de réalisation, le signal analogique est suréchantillonné.

Selon un mode de réalisation, le procédé comprend en outre la sélection du niveau de référence de chaque comparateur parmi une pluralité de niveaux de tension discrète.

Selon un mode de réalisation, le nombre de comparateurs est supérieur ou égal à deux, et les niveaux de référence des comparateurs sont sélectionnés de sorte d'être des niveaux successifs parmi la pluralité de niveaux de tension discrète.

Selon un mode de réalisation, le procédé comprend en outre la conversion du signal de commande, par au moins un convertisseur numérique analogique relié à une sortie du contrôleur, en un niveau de tension fourni à un diviseur de tension, formé d'une pluralité de résistances ou diodes connectées en série, compris dans un générateur de niveaux de référence.

Selon un mode de réalisation, le procédé comprend en outre la sélection des niveaux de référence sur la base du signal de commande, par un multiplexeur relié à une sortie d'un générateur de niveaux de référence comprenant un diviseur de tension formé d'une pluralité de résistances ou diodes connectées en série.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de convertisseur analogique numérique flash ;
la figure 2 est un graphe d'une tension d'un signal analogique et d'une tension d'un signal numérique correspondant après conversion par un convertisseur analogique numérique ;
la figure 3A représente schématiquement un convertisseur analogique numérique selon un mode de réalisation de la présente description ;
la figure 3B représente schématiquement un générateur de niveaux de référence selon un mode de réalisation de la présente description ;
la figure 3C est un organigramme d'un exemple d'algorithme de choix des niveaux de référence à sélectionner du convertisseur analogique numérique de la figure 3A ;
la figure 4 représente graphiquement un exemple d'évolution de la tension de signaux présents dans le dispositif de la figure 3A au cours du temps ;
la figure 5 représente, sous forme d'organigramme, un procédé de conversion d'un signal analogique selon un mode de réalisation de la présente description ;
la figure 6 représente graphiquement un exemple d'évolution de la tension au cours du temps de signaux présents dans le dispositif de la figure 3A, dans le cas où le dispositif de la figure 3A ne comprend qu'un seul comparateur ; et
la figure 7 représente schématiquement un convertisseur analogique numérique de type sigma-delta.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10% près, de préférence à 5% près.

Dans la description qui suit, on définit un signal suréchantillonné par un signal dont la fréquence d'échantillonnage est supérieure à la fréquence de Nyquist.

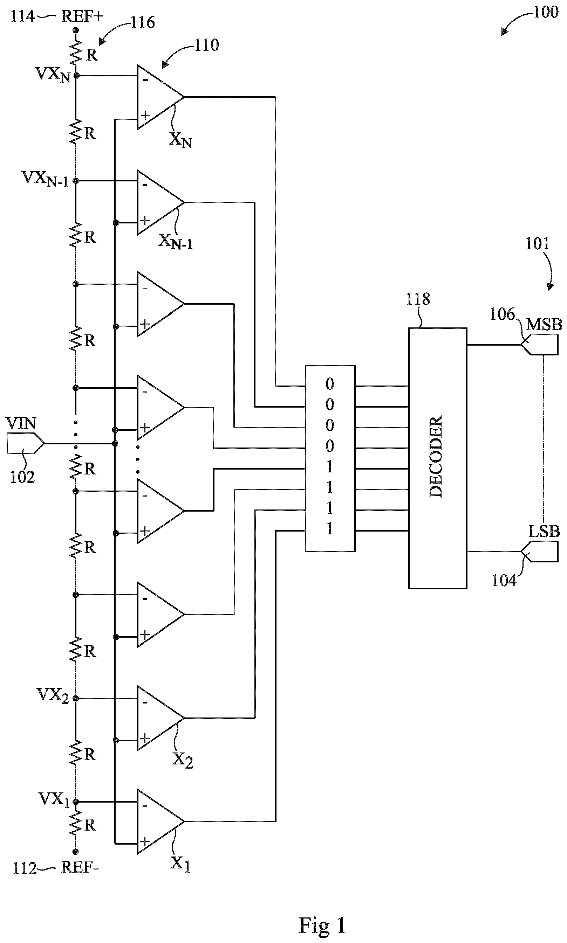

La figure 1 représente un exemple de convertisseur analogique numérique flash 100, parfois également appelé convertisseur analogique numérique parallèle.

Le dispositif 100 prend en entrée un signal analogique 102 (« VIN ») et est configuré pour le convertir en un signal numérique 101 composé de N bits allant d'un bit de poids faible 104 (en anglais, « least significant bit », LSB) à un bit de poids fort 106 (en anglais, « most significant bit », MSB) . Le convertisseur 100 comprend N comparateurs X₁, X₂, ..., X_{N-1}, X_{N} référencés collectivement 110 prenant chacun le signal analogique 102 à leur entrée positive et une tension de référence à leur entrée négative. Selon un autre mode de réalisation, non illustré en figure 1, les comparateurs prennent chacun le signal analogique 102 à leur entrée négative et une tension de référence à leur entrée positive. Les tensions de référence sont fixées par un diviseur de tension 116 comprenant une première 112 et une deuxième 114 bornes de tension d'alimentation en tension et un ensemble de résistances connectées en série entre les deux bornes. La première borne de tension 112 est à une première tension REF-, par exemple reliée à un rail de masse, et la deuxième borne de tension 114 est à une deuxième tension REF+, par exemple reliée à un rail de tension d'alimentation. La première tension REF- est inférieure à la deuxième tension REF+. Les résistances du diviseur de tension 116 ont par exemple la même valeur de résistance « R ». Un ensemble de N valeurs de tensions croissantes et régulièrement espacées Vx₁, Vx₂, ..., Vx_{(N-1)}, Vx_{N} est ainsi obtenu aux noeuds reliant les résistances entre elles. Les tensions Vx₁, Vx₂, ..., Vx_{(N-1)}, Vx_{N} sont les tensions de référence, également appelées niveaux de référence et sont reliées aux comparateurs X₁, X₂, ..., X_{N-1}, X_{N} respectivement. Chacun des comparateurs de l'ensemble 110 transmet en sortie un signal numérique ayant par exemple une tension haute (« 1 ») si le signal d'entrée 102 est supérieur au signal de référence du comparateur et une tension basse (« 0 ») si le signal d'entrée 102 est inférieur au signal de référence du comparateur. Les sorties des comparateurs 110 sont reliées à un décodeur 118 (« DECODER ») qui transmet en sortie le signal numérique 101 sous forme de bits allant du bit de poids faible 104 au bit de poids fort 106.

Un convertisseur analogique numérique tel que le dispositif 100 comprenant N comparateurs catégorise les valeurs prises par le signal analogique 102 parmi N+1 niveaux de tension. L'augmentation du nombre de niveaux et donc de la précision et/ou de la plage de tension du convertisseur s'accompagne d'une augmentation linéaire du nombre de comparateurs et donc de l'espace et de la consommation d'énergie requise.

Bien que le diviseur de tension 116 de la figure 1 soit réalisé par des résistances en série, dans un autre mode de réalisation, des diodes sont utilisées.

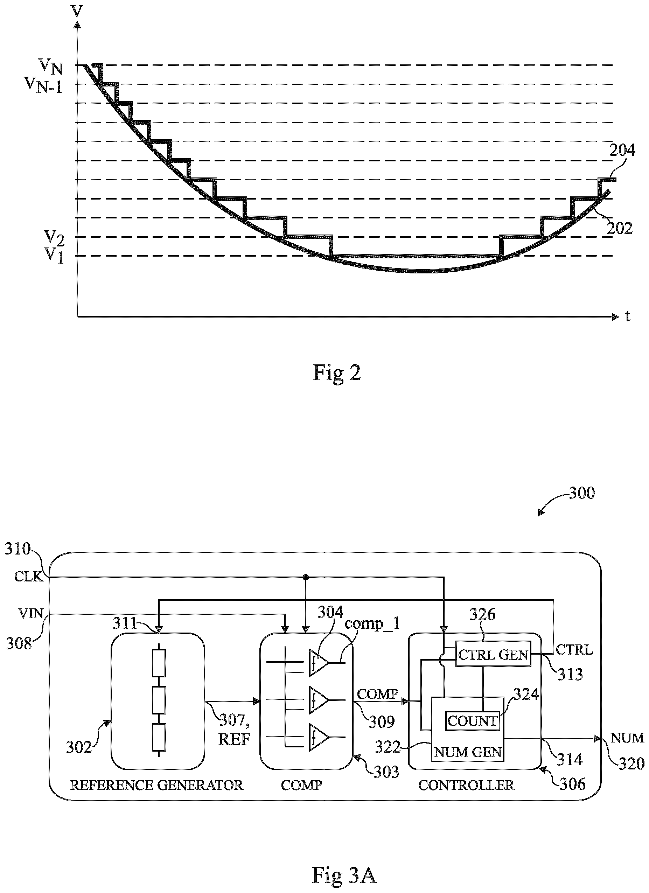

La figure 2 est un graphe d'une tension (« V ») d'un signal analogique 202 et d'une tension d'un signal numérique 204 correspondant après conversion par un convertisseur analogique numérique.

Le signal analogique 202 varie continument au cours du temps (« t »). Le signal numérique 204 ne peut prendre qu'un nombre fini de valeurs discrètes V₁, V₂, ..., V_{N-1}, V_{N} correspondant au nombre de niveaux du convertisseur.

La valeur du signal analogique 202 est par exemple échantillonnée, et les échantillons convertis en valeurs numériques à intervalles de temps réguliers, par exemple régis par un signal d'horloge.

La figure 3A représente schématiquement un convertisseur analogique numérique 300 selon un mode de réalisation.

Le convertisseur analogique numérique 300 fait par exemple parti d'un convertisseur de type Sigma-Delta.

Le convertisseur analogique numérique 300 comprend une première entrée 308 configurée pour recevoir un signal analogique VIN, une deuxième entrée 310 configurée pour recevoir un signal d'horloge CLK et une sortie 320 configurée pour fournir un signal numérique de sortie NUM.

Le convertisseur analogique numérique 300 comprend trois modules : un générateur de niveaux de référence 302 (« REFERENCE GENERATOR »), un ensemble de comparateurs 303 (« COMP ») et un contrôleur 306 (« CONTROLLER »).

Le générateur de niveaux de référence 302 est par exemple capable de générer n'importe quelle tension parmi un ensemble de N niveaux de tension de référence, N étant égal à au moins deux et étant choisi par exemple en fonction de la fréquence d'échantillonnage du signal analogique, de l'amplitude des variations du signal analogique, du nombre de comparateurs 304, etc. Dans certains cas, le générateur de niveaux de référence 302 est réalisé par un diviseur de tension comprenant par exemple un ensemble de N+1 résistances connectées en série entre deux bornes de tension. Dans certains cas, le générateur 302 est mis en oeuvre par le diviseur de tension 116 du dispositif 100 de la figure 1. Le générateur de niveaux de référence 302 comprend par exemple N noeuds de tension, chacun intermédiaire à deux résistances voisines, correspondant à N valeurs de tension distinctes et croissantes, par exemple les tensions Vx₁, Vx₂, ..., Vx_{(N-1)}, Vx_{N} de la figure 1. Le générateur de niveaux de référence 302 est par exemple configuré pour générer à M sorties 307 un nombre M, compris entre 2 et N, niveaux de référence REF. Le nombre M correspond au nombre de comparateurs 304 dans l'ensemble de comparateurs 303. De plus, les M niveaux de référence REF générés correspondent à M valeurs successives de tension parmi les N valeurs Vx₁, Vx₂, ..., Vx_{(N-1)}, Vx_{N}. Le générateur de niveaux de référence 302 a par exemple une entrée 311 reliée à une sortie 313 du contrôleur 306 et prend par exemple en entrée un signal de commande CTRL généré par le contrôleur 306. Le signal de commande CTRL indique les M niveaux de référence REF à transmettre.

Selon un mode de réalisation, le générateur de niveaux de référence 302 comprend M multiplexeurs, non représentés en figure 3A, chaque multiplexeur prenant par exemple en entrée toutes ou une partie des N tensions Vx₁, Vx₂, ..., Vx_{(N-1)}, Vx_{N} et étant commandé par le signal de commande CTRL pour transmettre chacun un des M niveaux de référence REF aux M sorties 307.

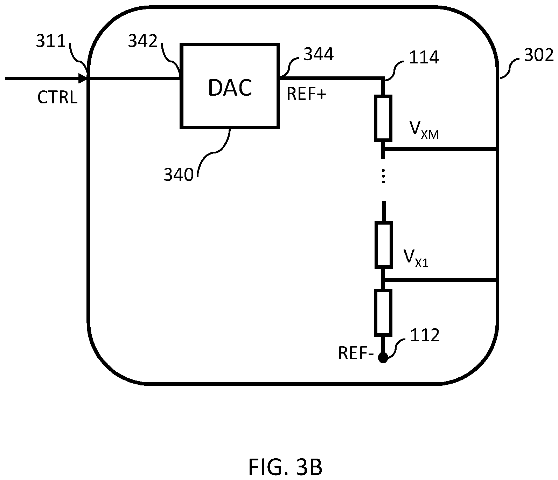

Selon un autre mode de réalisation, représenté en figure 3B, le générateur de niveaux de référence 302 comprend un nombre de résistances inférieur à N+1, par exemple égal à M+1.

La figure 3B représente schématiquement le générateur de niveaux de référence 302 selon ce mode de réalisation de la présente description.

Les résistances sont connectées en série entre les niveaux de tension d'alimentation REF- et REF+ (voir la figure 1), et le niveau de tension REF+ est variable et commandé par le signal de commande CTRL. Au moins un convertisseur numérique analogique 340 est alors présent dans le générateur de niveaux de référence 302. Le convertisseur numérique analogique 340 (« DAC », de l'anglais « Digital to Analog Converter ») est configuré pour convertir le signal de commande CTRL, reçu à une entrée 342 reliée à l'entrée 311, en un signal analogique, par exemple le signal analogique REF+, à une sortie 344 reliée à la borne de tension 114 de la figure 1. Le niveau de tension REF- est par exemple fixe et correspond par exemple à la tension du rail de masse, non représenté dans la figure 3B. Selon un autre mode de réalisation, les signaux REF- et REF+ sont tous les deux variables et fournis par deux convertisseurs numérique analogique, chacun commandé par le signal de commande CTRL.

En référence à nouveau à la figure 3A, et selon un autre mode de réalisation, non illustré en figure 3A, le générateur de niveaux de référence 302 comprend un ou plusieurs convertisseurs numériques analogiques reliés à une sortie du contrôleur 306 et configurés pour convertir le signal de commande CTRL numérique en M niveaux de tension de référence REF analogiques transmis aux M sorties 307.

L'ensemble de comparateurs 303 du convertisseur analogique numérique 300 comprend M comparateurs 304. Chacun des comparateurs 304 a une première entrée connectée au signal analogique VIN et une deuxième entrée connectée à l'une des M sorties 307 du générateur de tensions de référence 302. Chacun des M comparateurs 304 compare le signal analogique VIN à l'un des M niveaux correspondant de référence REF successifs. Par exemple, le signal analogique VIN est échantillonné, et les échantillons comparés avec les M niveaux de référence REF, à intervalles réguliers à une fréquence donnée par le signal d'horloge CLK. La fréquence d'échantillonnage définie par le signal d'horloge CLK est par exemple suffisamment élevée pour que le signal analogique VIN soit suréchantillonné. Par exemple, la fréquence d'échantillonnage est comprise entre 1 et 10 MHz, par exemple entre 5 et 7 MHz, pour une bande passante du signal VIN comprise entre 1 et 50 kHz, par exemple entre 15 et 25 kHz.

Selon des modes de réalisation, la fréquence d'échantillonnage est à la fréquence de Nyquist et le signal analogique VIN présente une dynamique faible, c'est-à-dire de faibles variations d'amplitude.

Selon d'autres modes de réalisation, le signal analogique VIN comprend un signal avec une faible fréquence et présentant une forte dynamique superposé à un signal avec une fréquence élevée et une dynamique faible.

Chacun des M comparateurs 304 transmet en sortie, sur la base de la comparaison, un signal numérique comp_1, ..., comp_M ayant par exemple une tension haute (« 1 ») si le signal analogique VIN est supérieur au signal de référence du comparateur correspondant et par exemple une tension basse (« 0 ») si le signal analogique VIN est inférieur au signal de référence du comparateur correspondant. L'ensemble des M signaux numériques COMP est transmis par M sorties 309 de l'ensemble de comparateurs 303.

Dans certains cas, l'écart entre 2 niveaux de référence REF successifs et la fréquence d'échantillonnage sont choisis de sorte que la variation d'amplitude du signal analogique VIN entre deux échantillons successifs ne dépasse pas deux fois ledit écart.

La génération du signal d'horloge CLK, par exemple par un circuit externe non représenté, est connue pour la personne du métier et ne sera pas détaillée.

Le contrôleur 306 comprend M entrées reliées aux M sorties 309 du module 303, ces M entrées étant configurées pour recevoir l'ensemble des signaux numériques COMP. Le contrôleur 306 comprend par exemple également une entrée configurée pour recevoir le signal d'horloge CLK. Le contrôleur 306 est configuré pour générer le signal numérique de sortie NUM à une sortie 314 du contrôleur 306, la sortie 314 étant reliée à la sortie 320 du dispositif 300. Le signal numérique de sortie NUM correspond à la conversion du signal analogique VIN par le dispositif 300 et est par exemple utilisé par d'autres circuits numériques externes non représentés. Le contrôleur 306 est également configuré pour générer le signal de commande CTRL à la sortie 313.

Le contrôleur 306 comprend par exemple un circuit 322 (« NUM GEN ») comprenant une entrée configurée pour recevoir le signal CLK et M entrées reliées aux M sorties 309 du module 303 afin de recevoir les signaux numériques COMP. Le circuit NUM GEN est configuré pour générer le signal numérique de sortie NUM. Le circuit NUM GEN comprend par exemple un compteur 324 (« COUNT ») configuré pour mémoriser un niveau représentant les niveaux de référence à appliquer aux comparateurs. Par exemple, le compteur COUNT mémorise le rang du niveau de référence REF le plus faible utilisé lors de la dernière comparaison. Selon un mode de réalisation, le circuit NUM GEN est configuré pour analyser l'ensemble des signaux COMP et en déduire, en utilisant la valeur enregistrée par le compteur lors de la comparaison précédente, le niveau de l'échantillon comparé. Le circuit NUM GEN est par exemple configuré pour mettre à jour la valeur du compteur et pour générer le signal NUM à la sortie 314.

Le contrôleur 306 comprend par exemple également un circuit 326 (« CTRL GEN ») comprenant une entrée configurée pour recevoir le signal CLK et M entrées reliées aux M sorties 309 afin de recevoir les signaux numériques COMP. Le circuit CTRL GEN est configuré pour générer le signal de commande CTRL à une sortie reliée à la sortie 313 du contrôleur 306. Selon un mode réalisation, le circuit CTRL GEN est configuré pour lire les valeurs des signaux COMP correspondant aux valeurs de référence REF maximale et minimale pour générer le signal de commande CTRL indiquant une variation des signaux de référence REF. Selon un autre mode réalisation, le circuit CTRL GEN comprend également une entrée reliée à une sortie du compteur COUNT du circuit NUM GEN et est par exemple configuré pour générer le signal de commande CTRL indiquant les valeurs de référence REF à appliquer pour la prochaine comparaison.

La génération des signaux NUM et CTRL par les circuits NUM GEN et CTRL GEN ainsi que l'incrémentation du compteur sont cadencés par le signal CLK.

Selon un autre mode de réalisation, le contrôleur 306 n'a pas d'entrée reliée au signal d'horloge CLK. Les signaux CTRL et NUM sont par exemple asynchrones et générés par une variation ou une lecture du signal COMP.

Selon un mode de réalisation, le dispositif 300 est configuré pour activer un nombre variable de comparateurs 304 au cours du temps et pour générer, par le générateur de niveaux de référence 302, le nombre de valeurs de référence REF correspondant au nombre de comparateurs activés. Les autres comparateurs sont par exemple désactivés. Le nombre de comparateurs 304 actifs varie par exemple pour suivre la vitesse de variation d'amplitude du signal analogique VIN. L'utilisation simultanée d'un grand nombre de comparateurs 304 permet de suivre de larges variations d'amplitude du signal analogique VIN dans le temps tandis que l'utilisation d'un nombre faible de comparateurs 304 permet de réduire temporairement la consommation du dispositif 300. Le contrôleur 306 est par exemple configuré pour effectuer le choix du nombre de comparateurs à utiliser pour chaque comparaison, par exemple en fonction de la vitesse des variations de niveaux enregistrées au cours des quelques comparaisons précédentes, par exemple enregistrées dans une mémoire du contrôleur 306. Par exemple, l'information de vitesse est indiquée par la variation de la valeur numérique NUM en sortie du dispositif 300 et/ou par des valeurs d'incrémentation et/ou de décrémentation de la valeur du compteur COUNT.

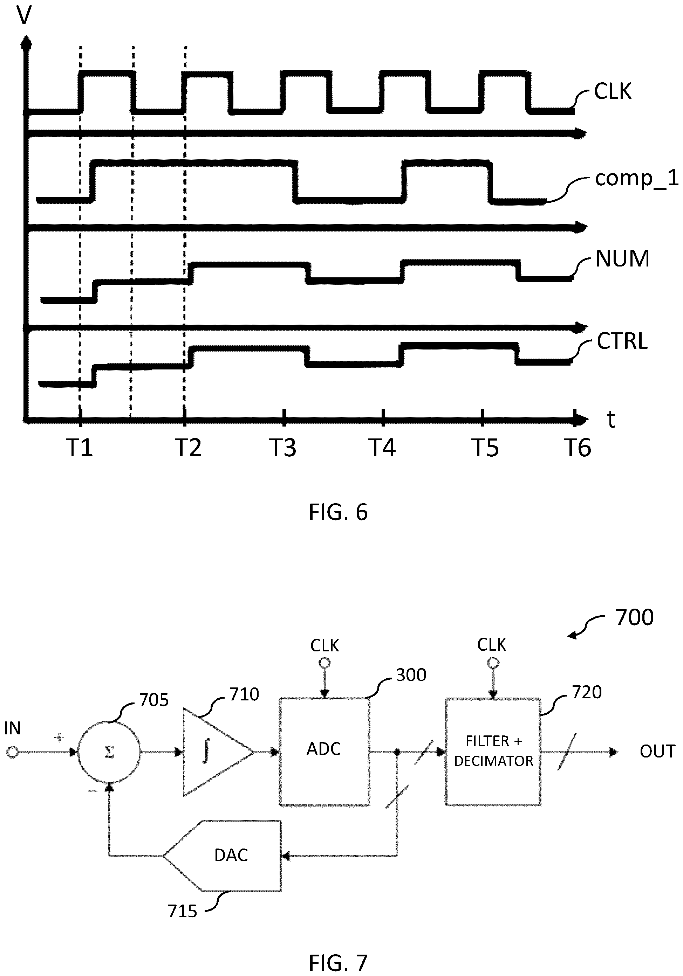

Selon un autre mode de réalisation, le dispositif 300 comprend un unique comparateur 304 et N tensions de référence REF possibles. Le nombre de comparateurs ne permet plus d'encadrer la valeur du signal analogique VIN au cours du temps. Selon un algorithme détaillé en figure 6, le dispositif 300 est configuré pour comparer la valeur des échantillons successifs du signal analogique VIN avec une valeur de référence qui évolue en fonction du résultat de la comparaison précédente. Le niveau du signal VIN est considéré atteint lorsque l'unique valeur de référence oscille autour de la valeur du signal analogique VIN. Dans ce mode de fonctionnement, le signal analogique VIN présente par exemple des variations d'amplitude lentes par rapport à la fréquence d'échantillonnage.

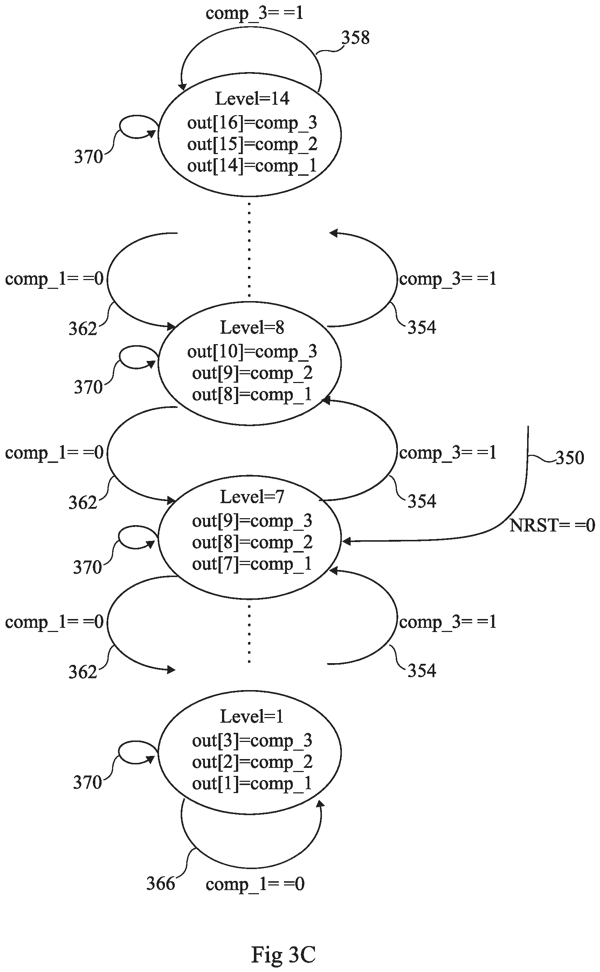

La figure 3C est un organigramme d'un exemple d'algorithme de choix des M niveaux de référence REF à sélectionner du convertisseur analogique numérique 300 de la figure 3A.

Dans l'exemple de la figure 3C, le convertisseur 300 comprend 17 résistances, et est capable de générer 16 valeurs de tension de référence REF. Le convertisseur 300 comprend également et 3 comparateurs.

La figure 3C représente des états que peut prendre le contrôleur 306, qui correspondent aux valeurs de niveaux (« Level ») stockées par le compteur COUNT.

Lors d'une étape d'initialisation 350 (« NRST==0 »), par exemple lorsque le dispositif 300 est allumé, le compteur COUNT est par exemple initialisé au 7^{ème} niveau (« Level=7 ») et les 3 niveaux de référence REF prennent la 7^{ème}, la 8ème et la 9^{ème} valeur de référence. Le signal analogique VIN est comparé aux 3 niveaux de référence REF par les trois comparateurs, un premier comparateur comparant le signal VIN au niveau de référence le plus faible (par exemple la 7^{ème} valeur lorsque le compteur est au 7^{ème} niveau), un deuxième comparateur comparant le signal VIN au niveau de référence médian (la 8^{ème} valeur lorsque le compteur est au 7^{ème} niveau) et un troisième comparateur comparant le signal VIN au niveau de référence le plus élevé (la 9^{ème} valeur lorsque le compteur est au 7^{ème} niveau). Les trois comparateurs 304 génèrent trois signaux numériques comp_1, comp_2 et comp_3 caractéristiques de la comparaison (« out[7]=comp_1 », « out[8]=comp_2 » et « out[9]=comp_3 »).

Dans l'exemple de la figure 3C, le contrôleur 306 analyse les signaux numériques COMP du premier comparateur, ayant la plus faible valeur de référence, et du troisième comparateur, ayant la plus haute valeur de référence.

Si le troisième comparateur a une tension de sortie haute (« comp_3==1 »), dans une étape 354, le contrôleur 306 est configuré pour incrémenter le compteur COUNT et pour générer le signal de commande CTRL indiquant au générateur 302 de passer aux niveaux supérieurs de référence. Le contrôleur 306 passe donc à l'état correspondant au niveau 8 (« Level=8 »), et les 3 niveaux de référence REF prennent la 8^{ème}, la 9^{ème} et la 10^{ème} valeurs de référence.

A l'état correspondant au niveau 8, le signal analogique VIN est comparé aux 3 niveaux de référence REF et les trois comparateurs 304 génèrent trois signaux numériques comp_1, comp_2 et comp_3 caractéristiques de la comparaison (« out[8]=comp_1 », « out[9]=comp_2 » et « out[10]=comp_3 »). Si le troisième comparateur a encore une tension de sortie haute (« comp_3==1 »), le contrôleur 306 répète l'étape 354 afin de passer à l'état supérieur (non représenté dans la figure 3C) et est configuré pour générer le signal de commande CTRL indiquant au générateur 302 de passer aux niveaux supérieurs de référence.

L'étape 354 est répétée tant que le troisième comparateur a une tension de sortie haute jusqu'à atteindre l'état maximal, correspondant au niveau 14 (« Level=14 ») dans cet exemple. Les 3 niveaux de référence REF prennent alors la 14^{ème}, la 15^{ème} et la 16^{ème} valeur de référence. Le signal analogique VIN est comparé aux 3 niveaux de référence REF. Les trois comparateurs 304 génèrent trois signaux numériques comp_1, comp_2 et comp_3 caractéristiques de la comparaison (« out[14]=comp_1 », « out[15]=comp_2 » et « out[16]=comp_3 »). Si le troisième comparateur a encore une tension de sortie haute (« comp_3==1 »), le contrôleur 306, dans une étape 358, est configuré pour générer le signal de commande CTRL indiquant au générateur 302 de rester au niveau maximal.

Si, lorsque le contrôleur est dans l'état correspondant au niveau 8, le premier comparateur a une tension de sortie basse (« comp_1==0 »), le contrôleur 306, dans une étape 362, est configuré pour décrémenter le compteur COUNT et pour générer le signal de commande CTRL indiquant au générateur 302 de passer aux niveaux inférieurs de référence. Le contrôleur 306 passe donc à l'état correspondant au niveau 7 (« Level=7 »).

A l'état correspondant au niveau 7, si le premier comparateur comp_1 a encore une tension de sortie basse (« comp_1==0 »), le contrôleur 306 répète l'étape 362 afin de passer à l'état inférieur (non représenté dans la figure 3C) et est configuré pour générer le signal de commande CTRL indiquant au générateur 302 de passer aux niveaux inférieurs de référence.

L'étape 362 est répétée tant que le premier comparateur a une tension de sortie basse jusqu'à atteindre l'état minimal, correspondant au niveau 1 (« Level=1 ») dans cet exemple. Les 3 niveaux de référence REF prennent alors la 1^{ère}, la 2^{ème} et la 3^{ème} valeur de référence. Le signal analogique VIN est comparé aux 3 niveaux de référence REF. Les trois comparateurs 304 génèrent trois signaux numériques comp_1, comp_2 et comp_3 caractéristiques de la comparaison (« out[1]=comp_1 », « out[2]=comp_2 » et « out[3]=comp_3 »).

Si le premier comparateur a encore une tension de sortie basse (« comp_1==0 »), le contrôleur 306, dans une étape 366, est configuré pour générer le signal de commande CTRL indiquant au générateur 302 de rester au niveau minimal.

Dans cet algorithme, si le premier comparateur a une tension de sortie basse, le contrôleur 306 est configuré pour décrémenter le compteur COUNT et pour générer le signal de commande CTRL indiquant au générateur 302 de passer au niveau inférieur. Si le troisième comparateur a une tension de sortie haute, le contrôleur 306 est configuré pour incrémenter le compteur COUNT et pour générer le signal de commande CTRL indiquant au générateur 302 de passer au niveau supérieur. Si le premier comparateur a une tension de sortie haute et que le troisième comparateur a une tension de sortie basse, alors le niveau actuel est considéré comme adapté et le contrôleur 306, dans une étape 370, est configuré pour ne pas modifier la valeur du compteur COUNT et pour générer le signal de commande CTRL indiquant au générateur 302 de rester au niveau actuel et de générer les mêmes niveaux de référence REF.

Un exemple d'évolution des niveaux de référence suivant cet algorithme est décrit dans la table 1 ci-dessous pour le dispositif 300.

**[Table 1]**

| | **T1** | **T2** | **T3** | **T4** | **T5** | **T6** |
|---|---|---|---|---|---|---|
| Vx 5 | | | 0 | 0 | 0 | |
| Vx 4 | 0 | 1 | 1 | 0 | 0 | 0 |
| Vx₃ | 1 | 1 | 1 | 1 | 0 | 0 |
| Vx 2 | 1 | 1 | | | | 1 |

La première colonne représente des exemples de valeurs de tensions de référence (Vx₂, Vx₃, Vx₄, Vx₅) et les six colonnes suivantes représentent l'état du signal de sortie REF des trois comparateurs pour six périodes (T1, T2, T3, T4, T5, T6) du signal d'horloge CLK.

Dans l'exemple de la table 1, au début de la période T1, le générateur 302 est au niveau 2 et les niveaux de référence Vx₂, Vx₃ et Vx₄ sont transmis par le module 302 aux trois comparateurs du module 303. Les deux comparateurs prenant Vx₂ et Vx₃ en entrée transmettent en sortie les signaux numériques COMP ayant une tension haute (« 1 ») signifiant que le signal analogique VIN a une tension supérieure aux tensions Vx₂ et Vx₃ et le comparateur prenant Vx₄ en entrée transmet en sortie le signal numérique ayant une tension basse (« 0 ») signifiant que le signal analogique VIN a une tension inférieure à la tension Vx₄. On est dans le cas où le premier comparateur a une tension de sortie haute et que le troisième comparateur a une tension de sortie basse. Le contrôleur 306 est donc configuré pour générer le signal de commande CTRL indiquant au générateur 302 de rester au niveau actuel et de générer les mêmes niveaux de référence REF.

Au début de la période T2, le générateur 302 est au niveau 2 et les niveaux de référence Vx₂, Vx₃ et Vx₄ sont transmis par le module 302 aux trois comparateurs du module 303. Les trois comparateurs transmettent en sortie les signaux numériques COMP ayant une tension haute signifiant que le signal analogique VIN a une tension supérieure aux tensions Vx₂, Vx₃ et Vx₄. On est dans le cas où le troisième comparateur a une tension de sortie haute. Le contrôleur 306 est donc configuré pour générer le signal de commande CTRL indiquant au générateur 302 de passer au niveau supérieur, au niveau 3.

Au début de la période T3, le générateur 302 est au niveau 3 et les niveaux de référence Vx₃, Vx₄ et Vx₅ sont transmis par le module 302 aux trois comparateurs du module 303. Les deux comparateurs prenant Vx₃ et Vx₄ en entrée transmettent en sortie le signal numérique ayant une tension haute signifiant que le signal analogique VIN a une tension supérieure aux tensions Vx₃ et Vx₄ et le comparateur prenant Vx₅ en entrée transmet en sortie le signal numérique ayant une tension basse signifiant que le signal analogique VIN a une tension inférieure à la tension Vx₅. On est dans le cas où le premier comparateur a une tension de sortie haute et que le troisième comparateur a une tension de sortie basse. Le contrôleur 306 est donc configuré pour générer le signal de commande CTRL indiquant au générateur 302 de rester au niveau actuel et de générer les mêmes niveaux de référence REF.

Au début de la période T4, le générateur 302 est au niveau 3 et les niveaux de référence Vx₃, Vx₄ et Vx₅ sont transmis par le module 302 aux trois comparateurs du module 303. Le comparateur prenant Vx₃ en entrée transmet en sortie le signal numérique ayant une tension haute signifiant que le signal analogique VIN a une tension supérieure à la tension Vx₃. Les deux comparateurs prenant Vx₄ et Vx₅ en entrée transmettent en sortie le signal numérique ayant une tension basse signifiant que le signal analogique VIN a une tension inférieure aux tensions Vx₄ et Vx₅. On est dans le cas où le premier comparateur a une tension de sortie haute et que le troisième comparateur a une tension de sortie basse. Le contrôleur 306 est donc configuré pour générer le signal de commande CTRL indiquant au générateur 302 de rester au niveau actuel et de générer les mêmes niveaux de référence REF.

Au début de la période T5, le générateur 302 est au niveau 3 et les niveaux de référence Vx₃, Vx₄ et Vx₅ sont transmis par le module 302 aux trois comparateurs du module 303. Les trois comparateurs transmettent en sortie le signal numérique ayant une tension basse signifiant que le signal analogique VIN a une tension inférieure aux tensions Vx₃, Vx₄ et Vx₅. On est dans le cas où le premier comparateur a une tension de sortie basse. Le contrôleur 306 est donc configuré pour générer le signal de commande CTRL indiquant au générateur 302 de passer au niveau inférieur, au niveau 2.

Au début de la période T6, le générateur 302 est au niveau 2 et les niveaux de référence Vx₂, Vx₃ et Vx₄ sont transmis par le module 302 aux trois comparateurs du module 303. Le comparateur prenant Vx₂ en entrée transmet en sortie le signal numérique ayant une tension haute signifiant que le signal analogique VIN a une tension supérieure à la tension Vx₂. Les deux comparateurs prenant Vx₃ et Vx₄ en entrée transmettent en sortie le signal numérique ayant une tension basse signifiant que le signal analogique VIN a une tension inférieure aux tensions Vx₃ et Vx₄. On est dans le cas où le premier comparateur a une tension de sortie haute et que le troisième comparateur a une tension de sortie basse. Le contrôleur 306 est donc configuré pour générer le signal de commande CTRL indiquant au générateur 302 de rester au niveau actuel et de générer les mêmes niveaux de référence REF.

Dans l'exemple de la Table 1, le dispositif 300 cherche à encadrer la valeur de tension du signal VIN et les niveaux de référence REF sont choisis pour suivre les variations du signal VIN au cours du temps.

La table 1 représente un exemple de programmation du contrôleur 306 et d'autres programmations sont possible pour le même signal analogique VIN et le même nombre de comparateurs. Par exemple, les niveaux de référence peuvent être décalés de deux niveaux au cours d'une période.

Un nombre différent de comparateurs peut être utilisé. Le nombre est par exemple choisi en fonction des variations anticipées du signal analogique VIN. Plus les variations du signal analogique VIN sont susceptibles d'être lentes, par exemple au plus un niveau par période du signal d'horloge CLK, moins le nombre de comparateurs a besoin d'être élevé.

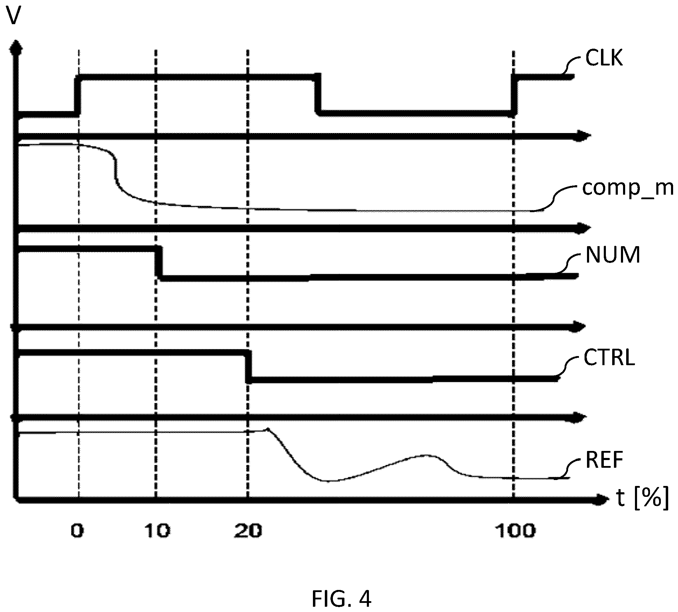

La figure 4 représente graphiquement un exemple d'évolution de la tension (« V ») de signaux CLK, comp_m, NUM, CTRL, REF présents dans le dispositif 300 de la figure 3A au cours du temps (« t [%] »), exprimé en pourcentage d'une période du signal d'horloge CLK.

La tension du signal d'horloge CLK, la tension comp_m d'un des M signaux numériques COMP de sortie d'un comparateur 304 du module 303, la tension du signal numérique de sortie NUM, la tension du signal de commande CTRL transmis par le contrôleur 306 et la tension d'un des M niveaux de référence REF sont représentés en figure 4.

Au début d'une période du signal d'horloge CLK, au temps 0%, par exemple à un front montant du signal d'horloge CLK, les comparateurs 304 du module 303 sont activés et comparent le signal analogique VIN aux niveaux de référence REF établis lors de la période précédente. Chacun des M signaux COMP converge vers une valeur représentative de la comparaison, par exemple sur la période de 0 à 10%. Le circuit NUM GEN du contrôleur 306 prend en entrée les signaux COMP et ajuste le niveau de tension du signal numérique de sortie NUM, par exemple au temps 10%. Le circuit CTRL GEN du contrôleur 306 reçoit le signal numérique NUM et est configuré pour générer le signal de commande CTRL, par exemple au temps 20%, utilisé par le module 302 pour la génération des niveaux de référence REF pour la période suivante. Par exemple sur la période de 20 à 100%, les niveaux de référence REF sont générés par le module 302 et convergent.

Dans l'exemple de la figure 4, le niveau de tension du signal comp_m représenté diminue, sur la période de 0 à 10%, témoignant d'une diminution de la tension du signal analogique VIN, non représenté sur la figure 4. En réponse, le niveau de tension du signal numérique de sortie NUM diminue, au temps 10%, et le niveau de tension du signal CTRL par exemple diminue, au temps 20%, le générateur 302 est alors configuré pour passer au niveau inférieur pour continuer de suivre l'évolution du signal analogique VIN. Le niveau de tension du signal REF représenté diminue, sur la période de 20 à 100%, correspondant à la diminution des niveaux de référence générés.

Selon un autre mode de réalisation, la période débute à un front descendant du signal d'horloge CLK.

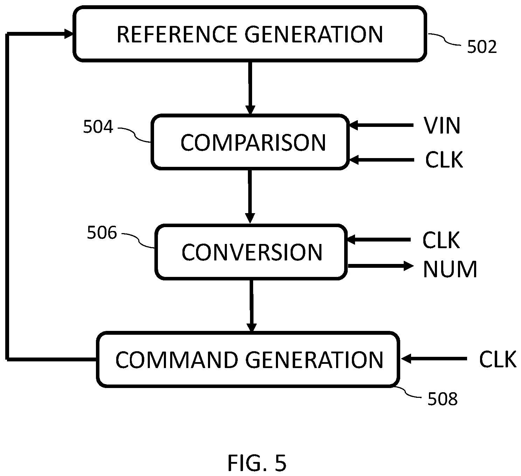

La figure 5 représente, sous forme d'organigramme, un procédé de conversion du signal analogique VIN de la figure 3A selon un mode de réalisation. Les étapes du procédé sont par exemple réalisées par le générateur de niveaux de référence 302, les comparateurs 304 et le contrôleur 306 de la figure 3A.

Dans une étape 502 (« REFERENCE GENERATION »), des niveaux de référence REF sont générés par le générateur de niveaux de référence 302. Lors de l'initialisation du dispositif, les niveaux de référence correspondent par exemple aux M niveaux médians parmi les N niveaux possibles.

Dans une étape 504 (« COMPARISON ») suivant l'étape 502, les niveaux de référence REF sont comparés au signal analogique VIN à un instant indiqué par le signal d'horloge CLK et les M signaux numériques COMP sont générés par le module 303.

Dans une étape 506 (« CONVERSION ») suivant l'étape 504, le signal numérique de sortie NUM est généré, par exemple par le circuit NUM GEN du contrôleur 306, à un instant indiqué par le signal d'horloge CLK et transmis à la sortie 320 du dispositif 300.

Dans une étape 508 (« COMMAND GENERATION ») suivant l'étape 506, le signal de commande CTRL est généré, par exemple par le circuit CTRL GEN du contrôleur 306, à un instant indiqué par le signal d'horloge CLK. Le signal de commande CTRL est transmis au module 302 pour la génération des nouveaux niveaux de référence REF et le procédé reprend à l'étape 502.

La figure 6 représente graphiquement un exemple d'évolution de la tension (« V ») au cours du temps (« t ») de signaux CLK, comp_1, NUM, CTRL présents dans le dispositif 300 de la figure 3A, dans le cas où le dispositif 300 ne comprend qu'un seul comparateur.

Si le module 303 du dispositif 300 de la figure 3A comprend au moins deux comparateurs, le niveau de tension du signal analogique VIN peut être encadré par deux niveaux de référence consécutifs, comme décrit dans l'exemple de la Table 1.

Au contraire, si le module 303 ne comprend qu'un unique comparateur, au cours d'une période donnée du signal d'horloge CLK, il est possible de déterminer un niveau minimum ou maximum pour le niveau de tension du signal analogique VIN. Il convient d'utiliser plusieurs périodes pour encadrer et connaître le niveau du signal analogique VIN.

Un exemple des signaux correspondant à l'application d'un algorithme spécifique est illustré en figure 6. Le signal d'horloge CLK oscille périodiquement entre deux valeurs de tension et les instants T1, ..., T6 correspondent aux fronts montants successifs. Au cours de la première période, entre T1 et T2, le signal analogique VIN est comparé à une première valeur de référence REF et le signal numérique comp_1 transmis par l'unique comparateur 304 passe à la tension haute donc la tension du signal analogique VIN est plus élevée que la première tension de référence. La tension du signal numérique de sortie NUM augmente indiquant une élévation du niveau de tension de VIN estimé. La tension du signal de commande CTRL augmente également pour qu'un niveau de référence plus élevé, correspondant à une deuxième tension de référence, soit utilisé au cours de la période suivante.

Entre T2 et T3, le signal analogique VIN est comparé à la deuxième valeur de référence REF et la tension du signal numérique comp_1 reste à la tension haute. La tension du signal analogique VIN est donc plus élevée que la deuxième tension de référence. La tension du signal numérique de sortie NUM augmente indiquant une élévation du niveau de tension de VIN estimé. La tension du signal de commande CTRL augmente également pour qu'un niveau de référence plus élevé, correspondant à une troisième tension de référence, soit utilisé au cours de la période suivante.

Entre T3 et T4, la tension du signal numérique comp_1 passe à la tension basse ce qui signifie que la tension du signal analogique VIN est inférieure à la troisième tension de référence. La tension du signal numérique de sortie NUM diminue indiquant une diminution du niveau de tension de VIN estimé et la tension du signal de commande CTRL diminue également pour qu'un niveau de référence plus faible, par exemple correspondant à la deuxième valeur de référence, soit utilisé au cours de la période suivante.

Entre T4 et T5, la tension du signal numérique comp_1 passe à la tension haute donc le niveau de tension du signal analogique VIN est plus élevé que la deuxième tension de référence. La tension du signal numérique de sortie NUM augmente pour indiquer une élévation du niveau de tension de VIN estimé et la tension du signal de commande CTRL augmente également pour qu'un niveau de référence plus élevé, par exemple correspondant à la troisième valeur de référence, soit utilisé au cours de la période suivante.

Entre T5 et T6, la tension du signal comp_1 diminue ce qui signifie que la tension du signal analogique numérique VIN est inférieure à la troisième tension de référence. La tension du signal numérique de sortie NUM diminue indiquant une diminution du niveau de tension de VIN estimé et la tension du signal de commande CTRL diminue également pour qu'un niveau de référence plus faible, par exemple correspondant à la deuxième valeur de référence, soit utilisé au cours de la période suivante.

Dans l'exemple de la figure 6, une tension haute en sortie de l'unique comparateur conduit à une augmentation de la tension de référence pour la période suivante et une tension basse en sortie de l'unique comparateur conduit à une diminution de la tension de référence pour la période suivante. Un seul comparateur étant présent, il n'est pas possible d'encadrer simultanément le signal analogique VIN par deux valeurs de référence. Cependant, une oscillation entre deux valeurs de référence voisines est par exemple observée si le signal analogique VIN est compris entre ces deux valeurs, comme illustré entre T2 et T6 de la figure 6. Cela est possible pour une variation du signal analogique VIN plus lente que la fréquence du signal d'horloge CLK.

La figure 7 représente un schéma de principe d'un convertisseur analogique numérique de type sigma-delta 700 comprenant par exemple le convertisseur 300 de la figure 3A.

Le convertisseur analogique numérique de type sigma-delta 700 prend à une entrée un signal analogique d'entrée IN et est configuré pour générer un signal numérique OUT. Le convertisseur 700 comprend par exemple un soustracteur 705, un intégrateur 710 et un convertisseur analogique numérique (« ADC »), par exemple le convertisseur 300 de la figure 3A. Le convertisseur 700 comprend par exemple également, dans une boucle de rétroaction, un convertisseur numérique analogique 715 (« DAC ») prenant en entrée le signal de sortie de l'ADC 300 et configuré pour générer un deuxième signal analogique. Le soustracteur 705 comprend une première entrée reliée à l'entrée du convertisseur 700 et configurée pour recevoir le signal IN et une deuxième entrée configurée pour recevoir le deuxième signal analogique. Le soustracteur 705 est configuré pour générer un signal correspondant à la différence des deux signaux d'entrée et le transmettre à l'intégrateur 710. L'intégrateur 710 comprend un ou plusieurs étages d'intégration et est configuré pour intégrer le signal de sortie du soustracteur 705 et générer le signal analogique VIN. Le signal VIN est transmis au convertisseur analogique numérique 300 configuré pour réaliser la conversion du signal analogique VIN en le signal numérique NUM. Le convertisseur analogique numérique 300 reçoit en outre le signal d'horloge CLK et est configuré pour réaliser un échantillonnage du signal VIN, par exemple à une fréquence supérieure à la fréquence de Nyquist pour réaliser un suréchantillonnage. Le signal NUM est transmis au convertisseur numérique analogique 715. Le signal NUM est également transmis à un filtre numérique et un décimateur 720 (« FILTER + DECIMATOR ») configurés pour filtrer le signal NUM et générer le signal numérique OUT.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, un dispositif comprend par exemple plusieurs convertisseurs 300 configurés pour recevoir chacun un sous-ensemble des échantillons du signal analogique VIN.

Enfin, la mise en oeuvre pratique des modes de réalisation et variantes décrits est à la portée de la personne du métier à partir des indications fonctionnelles données ci-dessus. En particulier, des comparateurs de tension sont connus dans l'art et leur mise en oeuvre pratique est donc à la portée de la personne du métier.

## Revendications

1. Convertisseur analogique numérique (300), comprenant :
- un ou plusieurs comparateurs (304), chacun configuré pour comparer un signal analogique (VIN) avec un niveau de référence (REF) variable propre au comparateur ; et
- un contrôleur (306) relié à une sortie de l'un ou plusieurs comparateurs (304) et configuré pour générer un signal de commande (CTRL) indiquant le niveau de référence (REF) de chaque comparateur (304) en fonction d'un signal de sortie (comp_m) de chacun de l'un ou plusieurs comparateurs et configuré pour générer un signal numérique (NUM) de sortie sur la base du signal de sortie (comp_m) de chacun de l'un ou plusieurs comparateurs,
un écart entre deux niveaux de référence successifs et une fréquence d'échantillonnage du signal analogique étant choisis de sorte que la variation d'amplitude du signal analogique (VIN) entre deux échantillons successifs ne dépasse pas deux fois ledit écart.

2. Convertisseur analogique numérique selon la revendication 1, dans lequel le signal analogique (VIN) est suréchantillonné.

3. Convertisseur analogique numérique selon l'une quelconque des revendications 1 à 2, dans lequel le niveau de référence (REF) de chaque comparateur est sélectionné parmi une pluralité de niveaux de tension discrète.

4. Convertisseur analogique numérique selon la revendication 3, dans lequel le nombre de comparateurs (304) est supérieur ou égal à deux, et les niveaux de référence (REF) des comparateurs (304) sont sélectionnés de sorte d'être des niveaux successifs parmi la pluralité de niveaux de tension discrète.

5. Convertisseur analogique numérique selon l'une quelconque des revendications 1 à 4, comprenant en outre un générateur de niveaux de référence (302) des comparateurs (304), comprenant un diviseur de tension formé d'une pluralité de résistances ou de diodes connectées en série.

6. Convertisseur analogique numérique selon la revendication 5, dans lequel le générateur de niveaux de référence (302) comprend un multiplexeur configuré pour sélectionner les niveaux de référence (REF) sur la base du signal de commande (CTRL) .

7. Convertisseur analogique numérique selon l'une quelconque des revendications 1 à 6, comprenant en outre au moins un convertisseur numérique analogique relié à une sortie du contrôleur (306) et configuré pour convertir le signal de commande (CTRL) en un ou plusieurs niveaux de tension de référence (REF) fournis à l'un ou plusieurs comparateurs (304) ou fournis à une ou plusieurs bornes d'alimentation en tension (REF-, REF+) du générateur de niveaux de référence.

8. Convertisseur analogique numérique selon l'une quelconque des revendications 1 à 7, dans lequel le contrôleur (306) est en outre configuré pour déterminer un nombre de comparateurs à activer parmi les un ou plusieurs comparateurs (304), en fonction d'une variation d'amplitude du signal numérique (NUM) de sortie.

9. Convertisseur analogique numérique Delta-Sigma, comprenant le convertisseur analogique numérique selon l'une quelconque des revendications 1 à 8.

10. Procédé de conversion analogique numérique, comprenant :
- la comparaison, par un ou plusieurs comparateurs (304) d'un convertisseur analogique numérique (300), d'un signal analogique (VIN) avec un niveau de référence (REF) variable propre au comparateur ;
- le choix d'un écart entre deux niveaux de référence successifs et d'une fréquence d'échantillonnage du signal analogique de sorte que la variation d'amplitude du signal analogique (VIN) entre deux échantillons successifs ne dépasse pas deux fois ledit écart ;
- la génération d'un signal de commande (CTRL), par un contrôleur (306) relié à une sortie de l'un ou plusieurs comparateurs (304), indiquant le niveau de référence (REF) de chaque comparateur en fonction d'un signal de sortie (comp_m) de chacun de l'un ou plusieurs comparateurs ; et
- la génération d'un signal numérique de sortie (NUM), par le contrôleur (306), sur la base du signal de sortie (comp_m) de chacun de l'un ou plusieurs comparateurs.

11. Procédé de conversion analogique numérique selon la revendication 10, dans lequel le signal analogique (VIN) est suréchantillonné.

12. Procédé de conversion analogique numérique selon l'une quelconque des revendications 10 à 11, comprenant en outre la sélection du niveau de référence (REF) de chaque comparateur parmi une pluralité de niveaux de tension discrète.

13. Procédé de conversion analogique numérique selon la revendication 12, dans lequel le nombre de comparateurs (304) est supérieur ou égal à deux, et les niveaux de référence (REF) des comparateurs (304) sont sélectionnés de sorte d'être des niveaux successifs parmi la pluralité de niveaux de tension discrète.

14. Procédé de conversion analogique numérique selon l'une quelconque des revendications 10 à 13, comprenant en outre la conversion du signal de commande (CTRL), par au moins un convertisseur numérique analogique relié à une sortie du contrôleur (306), en un niveau de tension fournis à un diviseur de tension, formé d'une pluralité de résistances ou diodes connectées en série, compris dans un générateur de niveaux de référence (302).

15. Procédé de conversion analogique numérique selon l'une quelconque des revendications 10 à 13, comprenant en outre la sélection des niveaux de référence (REF) sur la base du signal de commande (CTRL), par un multiplexeur relié à une sortie d'un générateur de niveaux de référence (302) comprenant un diviseur de tension formé d'une pluralité de résistances ou diodes connectées en série.
